# NEUE EUROPÄISCHE PATENTSCHRIFT

(11) **EP 0 687 956 B2**
(45) Veröffentlichungstag und Bekanntmachung des Hinweises auf die Entscheidung über den Einspruch: **23.11.2005**
(45) Hinweis auf die Patenterteilung: 22.12.1999
(21) Anmeldenummer: 95107364.2
(22) Anmeldetag: 16.05.1995
(51) Int. Cl.: G03F 7/20

(54) **Beleuchtungseinrichtung**
Illumination device
Dispositif d'illumination

(30) Priorität: 17.06.1994 DE 4421053; 25.11.1994 DE 4441947
(43) Veröffentlichungstag der Anmeldung: 20.12.1995
(73) Patentinhaber: Carl Zeiss SMT AG, 73447 Oberkochen (DE)
(72) Erfinder: Wangler, Johannes, D-89551 Königsbronn (DE); Richter, Gerald, D-73453 Abtsgmünd (DE)

(56) Entgegenhaltungen:
- EP-A- 0 490 291
- EP-A- 0 564 264
- EP-A- 0 576 297
- EP-A- 0 627 643
- WO-A-94/20883
- DE-A- 4 219 809
- JP-A- 1 152 411
- JP-A- 5 102 003
- JP-A- 5 251 308
- JP-A- 6 118 657
- US-A- 4 426 696
- US-A- 4 623 776
- US-A- 5 164 584
- US-A- 5 245 384
- US-A- 5 309 198
- US-A- 5 357 312
- Lexikon der Optik, Spektrum Akademischer Verlag, 1999, Seiten 59,60,356
- RMS Dictionary of light microscopy, 1989, p.5,9,51,76,127,136
- Ernst Wörterbuch der ind. technik, 1989, Seiten 172,1019
- Naumann, Schröder: Bauelemente der Optik, 1983, Abschnitt 1.1

## Beschreibung

Die Erfindung betrifft eine Beleuchtungseinrichtung einer mikrolithographischen Projektions-Belichtungsanlage mit einem Zoom-Objektiv und zwei Axicons. Aus JP 5-251 308 A ist ein ähnliches Objektiv bekannt.

Aus W.N. Partlo et al., SPIE Vol. 1927, Optical/Laser Microlithography VI (1993), pp. 137-157 (Fig. 19, 20) ist eine Beleuchtungseinrichtung bekannt, bei der im kollimierten Strahlengang zwischen zwei Linsen im Bereich zwischen Lichtquelle und Lichtintegrator zwei Axicons angeordnet sind, eines konkav, eines konvex, mit ebenen zweiten Grenzflächen. Zur optimalen Ausleuchtung verschiedener Ringaperturblenden kann ihr Abstand von Null aus variiert werden, es kann also auch konventionelle Beleuchtung gemacht werden.

Aus EP 0 564 264 A1 ist es bekannt, zur Erzeugung einer Ringaperturbeleuchtung bei Wafer-Steppern eine konische Linse - ein Axicon - einzusetzen, bzw. zur Erzeugung einer Multipolbeleuchtung Pyramiden-Prismen (Fig. 7, 8). Auch die Anordnung von zwei Axicons ist dabei (Fig. 17, 19) bekannt, die zwei Axicons sind jedoch durch andere optische Elemente getrennt. Die konischen oder pyramidenförmigen Flächen sind beide konvex.

Die Brauchbarkeit auch konkav konischer Bauelemente in diesem Zusammenhang ist in JP 5/251 308 A offenbart.

EP 0 346 844 A1 zeigt die Verwendung von Paaren konvex konischer Linsen, deren Spitzen einander entgegengesetzt gerichtet sind, zur Beleuchtungs-Strahlaufspaltung für die Punktabbildung mit Überauflösung.

Aus US 5 208 629 ist für die Beleuchtung eines Wafer-Steppers die Verwendung von Pyramiden- oder Kegel-Axicon-Linsen, auch als konvex konkave Form, zur verlustarmen Bereitstellung einer symmetrischen schiefen Beleuchtung (Multipolbeleuchtung) bekannt. Eine Zoom-Funktion ist nicht damit verbunden.

Zoomsysteme zur Variation des Kohärenzgrades werden in Beleuchtungssystemen für Waferstepper mit Wabenkondensoren der Firma ASML aus den Niederlanden seit 1987 eingesetzt.

Aus US 5 237 367 ist die Verwendung eines Zoom in der Beleuchtungseinrichtung eines Wafer-Steppers zur verlustfreien Einstellung des Kohärenzgrads σ bekannt, und zwar bei konventioneller Beleuchtung.

Aus US 5 245 384 ist ein afokales Zoomsystem für die Beleuchtung bei Wafer-Steppern bekannt, mit dem der Kohärenzfaktor σ verlustarm angepasst werden kann. Ein Axicon ist nicht vorgesehen.

US 5 357 312 beschreibt ein Beleuchtungssystem in einem Belichtungsapparat für die Photolithographie mit einem ersten Axicon-Paar zur Beseitigung des zentralen dunklen Flecks, der bei üblichen Entladungslampen gegeben ist, einem verstellbaren Axicon-Paar zur wahlweisen Einstellung einer Ringapertur, einem Zoomsystem zur Anpassung des Beleuchtungsbündel-Durchmessers an eine als sekundäre Lichtquelle dienende Blende, und einem noch vor dieser Blende liegenden Wabenkondensor als Lichtintegrator. Es ist die serielle Anordnung all dieser Elemente in der beschriebenen Reihenfolge vorgesehen, wobei jeweils zwischen zwei Elementen parallele Strahlenbündel sein müssen.

EP 0 297 161 A1 gibt für eine Projektions-Belichtungsanlage mit Lichtleiter-Glasstab im Beleuchtungs-Strahlengang an, dass nach dem Glasstab ein Verlaufsfilter angebracht werden kann. Dies dient offenbar der weiteren Homogenisierung, nicht der Abblendung.

Die immer weiter fortschreitende Annäherung an die Auflösungs-Grenzen der optischen Projektion für die lithographische Mikrostrukturierung bringt das Erfordernis mit sich, dass die Beleuchtung entsprechend den Strukturen der einzelnen Vorlagen optimiert werden muss, das heißt, optimierte Ringapertur- oder Quadrupol-Beleuchtung und andere müssen eingestellt werden können.

Es ist daher die Aufgabe der Erfindung, eine besonders flexibel veränderbare Beleuchtungseinrichtung anzugeben, die durch Verstellen von Elementen, ohne Austausch, und mit möglichst hohem Wirkungsgrad, eine Vielzahl von Beleuchtungsmodi ermöglicht.

Gelöst wird die Aufgabe durch eine Beleuchtungseinrichtung mit den Merkmalen der Ansprüche 1 oder 2.

So ist es vorteilhaft, wenn eine zweite Grenzfläche eines Axicons eine Linsenwirkung hat und so das Zoom-Objektiv kompakter und einfacher im Aufbau wird.

Die so erreichte Flexibilität bei der Gestaltung des Lichtbündel-Querschnitts wird durch die Ausführung der Axicons mit gleichem Spitzenwinkel und die mögliche Reduzierung des Abstands der beiden Axicons bis zur Berührung gemäß den Unteransprüchen 3 und 4 optimiert. Insbesondere kann dann der Grenzfall der konventionellen Beleuchtung dargestellt werden.

Sind die Axicons konisch, so eignet sich die Anordnung besonders für Ringaperturbeleuchtung. Mit pyramidenförmigen Axicons wird dagegen eine Multipol-Beleuchtung optimiert.

Anspruch 7 beschreibt den besonderen Vorteil der erfindungsgemäßen Beleuchtungseinrichtung, dass nämlich konventionelle, Ringapertur- oder Multipolbeleuchtung sehr variabel einstellbar sind.

Vorteilhaft in der erfindungsgemäßen Beleuchtungseinrichtung integriert wird nach Anspruch 8 und 9 ein Glasstab als Lichtintegrator, an dessen Austritt ein Maskierungssystem angeordnet ist. Ein Reticle-Maskierungssystem direkt am Reticle, das - besonders wenn es verstellbar sein soll - dort problematisch ist, oder ein eigenes Zwischenabbildungssystem für ein Reticle-Maskierungssystem werden damit eingespart und der Bauaufwand wird bei gleichzeitig hoher Qualität vermindert.

Die Anordnung des üblichen Verschlusses, der zugleich eine Blende ist, außerhalb des Fokus des Lampenspiegels, ist eine generelle Zusatzmaßnahme zur Verbesserung der Homogenität der Beleuchtung, welche sich in Kombination mit den übrigen Merkmalen der Erfindung besonders bewährt.

Es wird mit der beschriebenen Beleuchtungseinrichtung möglich, die verschiedenen oben genannten Beleuchtungsarten einzustellen, ganz ohne Blenden zur Formung des Lichtbündels nach dem Lichtintegrator, die für verschiedene Beleuchtungsarten verstellbar oder wechselbar sein müssten. Die gesamte Formung geschieht durch Verstellen des Zoom-Axicon-Objektivs, was optimal dafür geeignet ist, um von einem Computer programmgesteuert zu erfolgen. Die hierbei erreichte Qualität der einzelnen Beleuchtungsmodi kann durch vermehrten Aufwand für die Zoom/Axicon-Baugruppe noch signifikant gesteigert werden.

Feste Blenden zur Unterdrückung von Streulicht und ähnlichem sind natürlich an jeder vorteilhaften Stelle im Strahlengang möglich.

Durch die Maßnahme nach Anspruch 13 gewinnt das Linsendesign zusätzliche Freiheit zur Anpassung der Zoom-Wirkung an die Axicon-Wirkung. Für großes σ, d.h. große ausgeleuchtete Fläche, wird der Intensitätsverlauf bei kleinen und bei großen Radien angehoben, die Ausleuchtung also gleichmäßiger.

Dabei ist es vorteilhaft, wenn das zusätzlich eingeführte Zoom-Element so ausgebildet ist, dass es bis zur Berührung an eine benachbarte Linse angenähert werden kann, insbesondere wenn beide auch gleiche Brechzahl aufweisen.

Gemäß Anspruch 16 wird die Einstellung mit kleiner ausgeleuchteter Fläche, also kleinem Kohärenzgrad σ erreicht, wenn beide verschiebbare Linsen fern von den beiden Axicons liegen, und großes σ wird erreicht, indem diese Linsen möglichst nah an die Axicons rücken.

Näher erläutert wird die Erfindung anhand der Zeichnung.

Es zeigen:

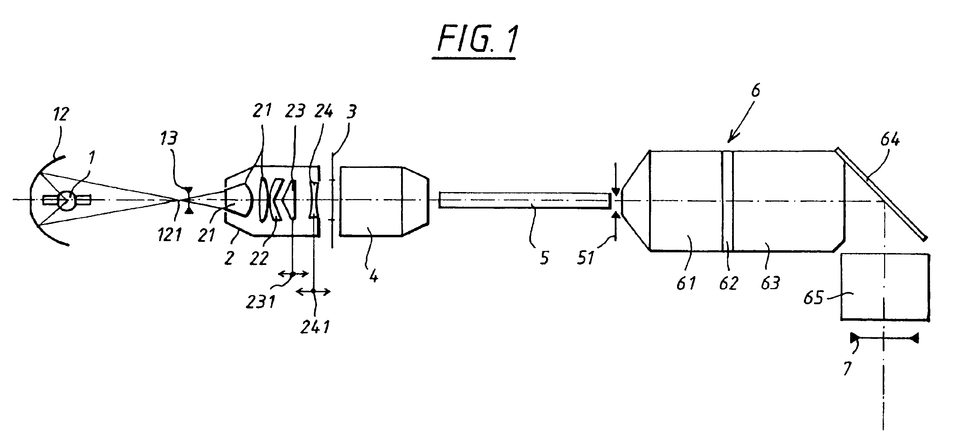

- Figur 1: die schematische Darstellung eines bevorzugten Ausführungsbeispiels einer erfindungsgemäßen Beleuchtungseinrichtung;

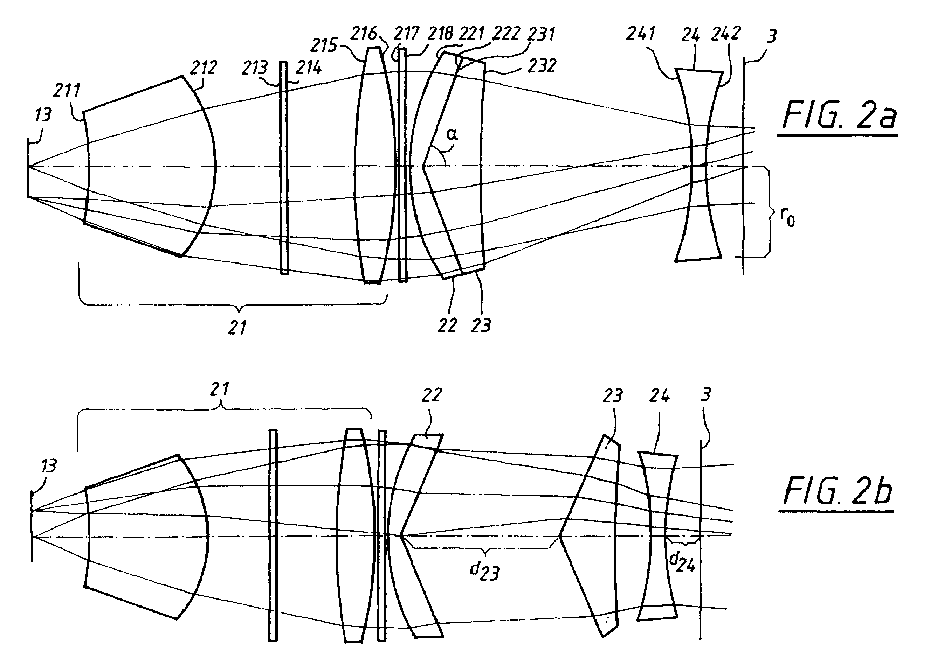

- Figur 2a: eine Ausführung des in Figur 1 enthaltenen Zoom-Axicon-Objektivs als Linsenschnitt bei auf Abstand Null zusammengerückten Axicons;
- Figur 2b: dasselbe wie Figur 2a, jedoch mit getrennten Axicons;

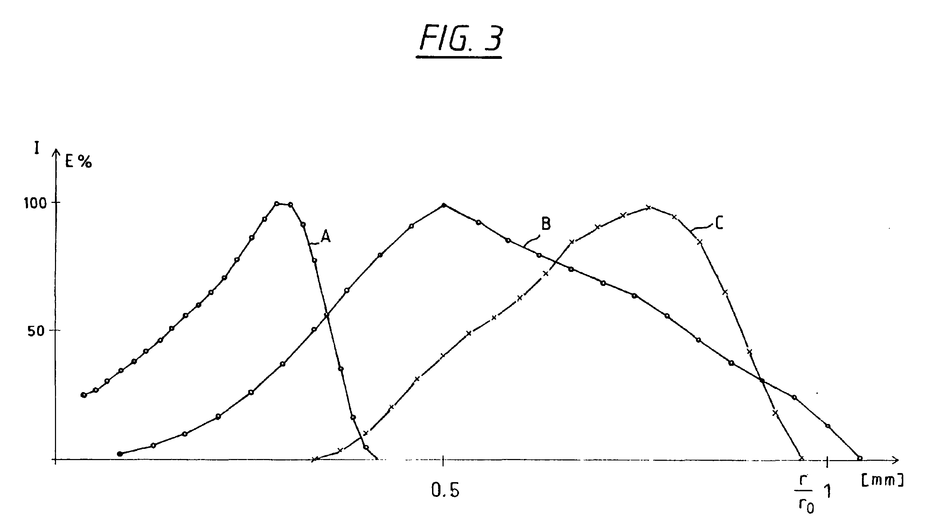

- Figur 3: den Intensitätsverlauf als Funktion des Radius in der Pupillenzwischenebene für verschiedene Zoom- und Axicon-Positionen der Anordnung nach Figur 2a und 2b;

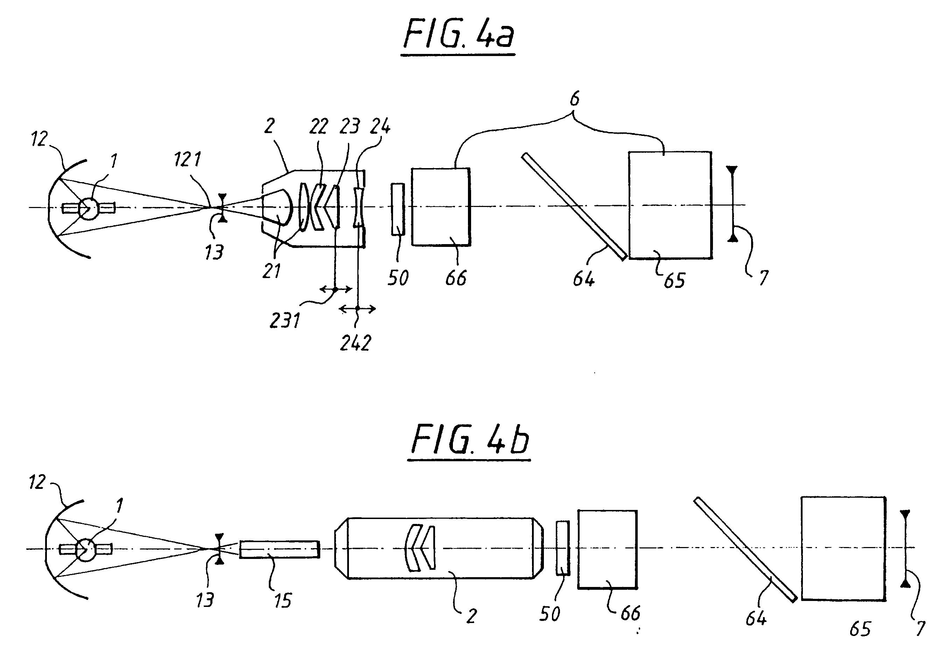

- Figur 4a: ein anderes Ausführungsbeispiel schematisch;
4b ein anderes Ausführungsbeispiel schematisch;
4c ein anderes Ausführungsbeispiel schematisch;
4d ein anderes Ausführungsbeispiel schematisch;

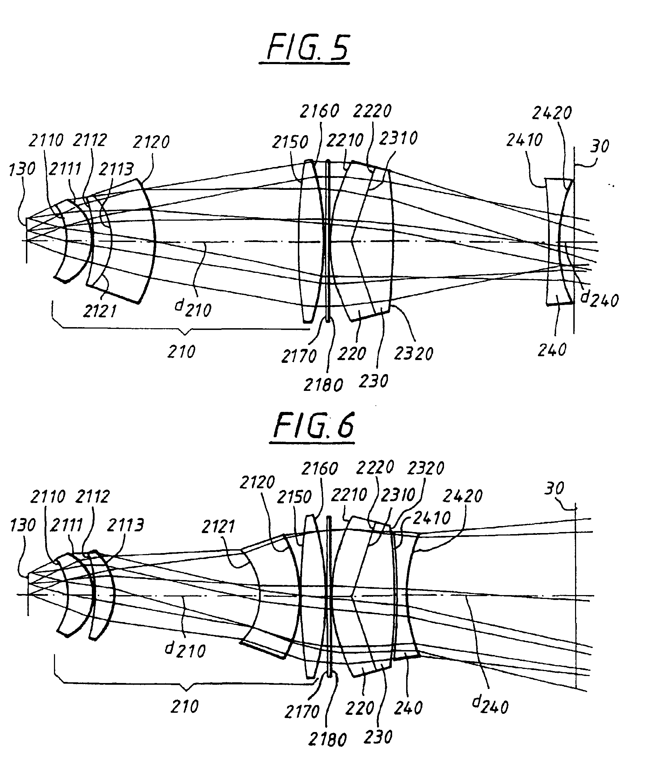

- Figur 5: die schematische Darstellung einer Ausführung des in einer erfindungsgemäßen Beleuchtungseinrichtung enthaltenen Zoom-Axicon-Objektivs als Linsenschnitt bei auf Abstand Null zusammengerückten Axicons und Stellung der Zoom-Elemente für minimale Ausleuchtung;
- Figur 6: dasselbe wie Figur 5, jedoch in der Stellung der Zoom-Elemente für größtmögliche Ausleuchtung;

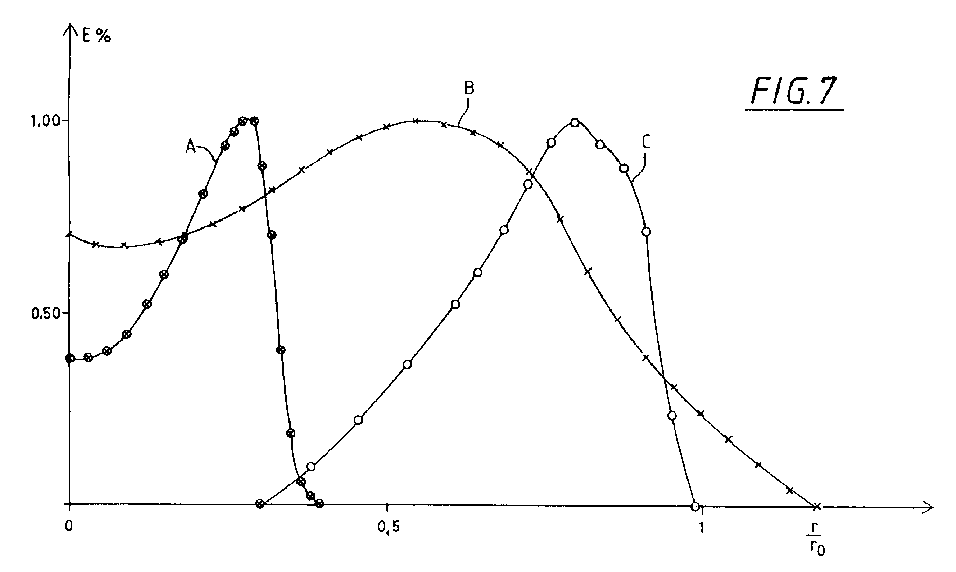

- Figur 7: den Intensitätsverlauf als Funktion des Radius in der Pupillenzwischenebene für verschiedene Zoom- und Axicon-Positionen der Anordnung nach Figur 5 und 6.

Figur 1 zeigt ein Beispiel einer erfindungsgemäßen Beleuchtungseinrichtung für die Projektions-Lithographie bei Auflösungen bis zu Bruchteilen von 1 µm, z.B. für die Herstellung integrierter Schaltkreise.

Eine Lampe (1), eine Quecksilber-Kurzbogenlampe für die i-Linie von 365 nm Wellenlänge, ist im einen Brennpunkt eines elliptischen Spiegels (12) angeordnet, der das emittierte Licht im zweiten Brennpunkt (121) sammelt.

Abweichend von der Regel ist der Verschluss (13) außerhalb des Brennpunktes (121) angeordnet, und zwar ist der Abstand zum Scheitel des elliptischen Spiegels (12) etwa 5% bis 20%, vorzugsweise 10%, größer als der Abstand des Brennpunkts (121) zum Scheitel. Dadurch wird erreicht, dass die hier gebildete sekundäre Lichtquelle homogener wird und die partiell kohärente Wirkung der Beleuchtung auf die optische Abbildung verbessert wird. Ein extra Misch-System zu diesem Zweck kann damit eingespart werden. Diese Maßnahme ist auch bei einer sonst konventionellen Beleuchtungseinrichtung sinnvoll.

Das folgende Objektiv (2) besteht aus einer ersten Linsengruppe (21), dem konkaven ersten Axicon (22), dem konvexen zweiten Axicon (23) und einer zweiten Linsengruppe (24). Stellmittel (231) und (241) erlauben die axiale Verschiebung eines Axicons (23) und eines Elements der zweiten Linsengruppe (24). Damit kann sowohl der Abstand der Axicons (22, 23) untereinander verstellt werden und somit der Ringaperturcharakter verändert werden, als auch eine Zoom-Wirkung zur Veränderung des ausgeleuchteten Pupillendurchmessers, also des Kohärenzgrads σ, erreicht werden.

Nach der Pupillenzwischenebene (3) folgt ein zweites Objektiv (4), mit dem das Licht in den Glasstab (5) von ca. 0,5 m Länge eingekoppelt wird. Der Ausgang des Glasstabs (5) ist eine Zwischenfeldebene, in der ein Maskierungssystem (51) angeordnet ist, das anstelle konventioneller REMA- (reticle masking) Systeme eingesetzt wird. Die sonst übliche Schaffung einer zusätzlichen Zwischenfeldebene für das REMA-System mit aufwendigen Linsengruppen wird eingespart.

Das folgende Objektiv (6) bildet die Zwischenfeldebene mit dem Maskierungssystem (51) auf das Reticle (7) (Maske, Lithographievorlage) ab und enthält eine erste Linsengruppe (61), eine Pupillen-Zwischenebene (62), in die Filter oder Blenden eingebracht werden können, zweite und dritte Linsengruppen (63 und 65) und dazwischen einen Umlenkspiegel (64), der es ermöglicht, die große Beleuchtungseinrichtung (ca. 3 m Länge) horizontal einzubauen und dabei das Reticle (7) waagerecht zu lagern.

Der für alle Ausführungsformen gemeinsame Teil der Beleuchtungseinrichtung ist das Objektiv (2), welches in der Figur 2a für ein Ausführungsbeispiel dargestellt ist. In der Tabelle 1 sind dafür die Linsendaten angegeben.

Die erste Linsengruppe (21) enthält zwei Linsen mit den Flächen (211, 212, 215, 216) und zwei Planplatten mit den Flächen (213, 214 und 217, 218), welche als Filter ausgebildet werden können.

Die beiden Axicons (22 und 23) haben gleiche Kegelwinkel α und können daher wie in dieser Figur 2a dargestellt, bis auf Berührung zusammen geschoben werden. Die Axicons (22, 23) haben in dieser Stellung keine Wirkung der Kegelflächen (222, 231) und bilden zusammen eine einfache Linse, da ihre zweiten Grenzflächen (221, 232) gekrümmt sind. Diese Linse ist von Bedeutung für die Korrektur des Objektivs 2, der Strahlengang an dem Axicon (22, 23) ist nicht kollimiert. Die Linse (24) ist axial verschieblich und macht die Anordnung zu einem Zoom-Objektiv konventioneller Bauart. Damit kann konventionelle Beleuchtung mit veränderlichem Pupillendurchmesser in der Pupillenebene (3), also mit veränderlichem Kohärenzfaktor σ vorzugsweise im Bereich 0,3 bis 0,8 dargestellt werden. Aber natürlich ist vorgesehen, die beiden Axicons (22, 23) mit dem Stellmittel (231) auf einen gewünschten Abstand auseinander zufahren.

Ein solcher Fall ist in Figur 2b dargestellt, die ansonsten völlig der Figur 2a entspricht.

Die zweite Linsengruppe (24) ist als eine einzelne bikonkave Linse mit den Flächen (241 und 242) ausgebildet. Die Verschlussebene (13) und die Pupillenebene (3) sind in den Figuren 2a, 2b ebenfalls dargestellt.

Figur 3 zeigt den Intensitätsverlauf (I) des Lichts als Funktion von r/r₀ in der Pupillenebene (3) für verschiedene Stellungen des Axicons (23) und der Linse (24). Die Kurve A gilt für die Stellung gemäß Fig. 2a, die Kurve B gilt für eine Stellung, bei der ausgehend von Fig. 2a die Linse (24) weitgehend an das Axicon (23) gerückt ist. Die Kurve C gilt für die von den Axicons 22,23 geprägte Stellung der Fig. 2b. Die Distanz d23 (222-231) - also der Abstand der Axicons (22, 23) - bestimmt dabei die verstärkte Ausprägung der Ringaperturbeleuchtung mit zentraler dunkler Scheibe. Letztere wächst mit zunehmender Distanz d23. Die Distanz d24 (242-3) bestimmt die Zoom-Wirkung, also den Gesamt-Durchmesser des Beleuchtungsflecks in der Pupillenebene (3). Die Ringaperturbeleuchtung hat einen hohen Wirkungsgrad, da sie ohne Ausblenden der mittleren Scheibe erzeugt wird. Ein (kleiner) dunkler Fleck auf der Achse bleibt auch bei ganz vereinigten Axicons (22, 23) gewöhnlich wegen der Bauform der Lampe (1) und des Hohlspiegels (12). Das ist zugleich bewusst gewollt und schafft Raum für die Unterbringung von Hilfssystemen, zum Beispiel für Fokussier- und Positioniersysteme. Bei Bedarf kann dies jedoch mit bekannten Mitteln, z.B. zusätzlichen festen Axicons vor dem Objektiv 2 abgestellt werden, vgl. z.B. US 5 357 312.

Zu einer Multipol-Beleuchtung (symmetrische schiefe Beleuchtung) gelangt man, wenn in die Pupillenebene (3) oder eine dazu äquivalente Ebene der Beleuchtungseinrichtung eine Mehrloch-Blende eingefügt wird, die aus dem Ringbündel z.B. nur vier Bündel durchlässt.

Besondere Beleuchtungsgeometrien lassen sich auch durch abweichende Formgebung der Axicons (22, 23), welche z.B. für die Quadrupolbeleuchtung pyramidenförmig mit quadratischer Grundfläche sein können, erzielen und unterstützen.

Weitere Varianten von erfindungsgemäßen Beleuchtungseinrichtungen werden in den Figuren 4a bis 4d dargestellt. Gleiche Teile haben dabei gleiche Bezugszeichen wie in Figur 1.

Figur 4a zeigt ein Ausführungsbeispiel, bei dem der Glasstab (5) der Figur 1 durch einen Wabenkondensor (50) ersetzt ist. Dies ist eine Alternative, die u.a. die Baulänge verringert. Allerdings entfällt hierbei die Option auf das oben beschriebene REMA-System. Das Objektiv (6) besteht aus den zwei Linsengruppen (66) und (65) mit zwischengeschaltetem Umlenkspiegel (64) (schematische Darstellung auf durchgehende optische Achse bezogen).

Figur 4b zeigt gegenüber Figur 4a einen zusätzlichen Glasstab (15) in der Art des Glasstabs (5) von Figur 1, angeordnet zwischen dem Verschluss(13) und dem Zoom-Axicon-Objektiv (2). Damit kann die Ausleuchtung der Pupillenebene auf dem Wabenkondensor (50) noch weiter homogenisiert werden. Das Zoom-Axicon-Objektiv (2) hat hier mehr Linsen und ist entsprechend länger.

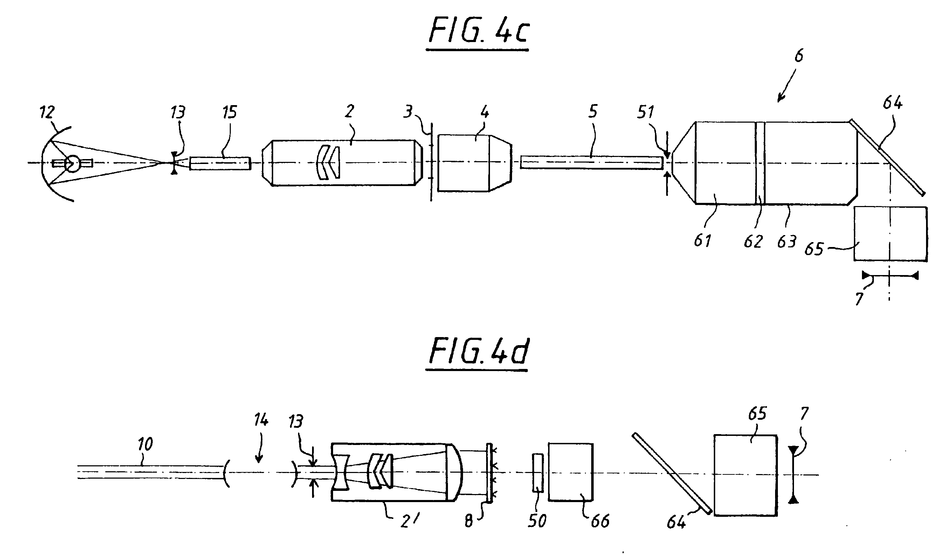

Figur 4c zeigt eine Anordnung gemäß Figur 1, jedoch mit dem zusätzlichen Glasstab (15) und dem längeren Zoom-Axicon (2) der Figur 4b.

Figur 4d zeigt eine Variante der erfindungsgemäßen Beleuchtungseinrichtung, bei der als Lichtquelle ein Laserstrahl (10) dient. Dies ist vorzugsweise ein Excimer-Laserstrahl mit einer Wellenlänge im tiefen UV-Bereich. Dabei ist die Form des Laserstrahls (10) typischerweise ein schmales Rechteck. Mit einer Strahlformungseinrichtung (14), z.B. nach DE 41 24 311 A1, wird der Laserstrahl (10) günstiger, typischerweise quadratisch, geformt und zugleich in der Kohärenz reduziert. Nach dem Verschluss (13) folgt ein modifiziertes Zoom-Axicon-Objektiv (2'), das hier als Strahlaufweitungs-Teleskop ausgebildet ist. Nach einer Streuscheibe oder einem Beugungselement (8) als weiter die Kohärenz reduzierender sekundärer Lichtquelle folgt, entsprechend angepasst, wie in Figur 4a und 4b der Wabenkondensor (50) und das Objektiv (6) bis zum Reticle (7). Natürlich kann auch mit der Laserlichtquelle ein Glasstab entsprechend den Fig. 1 und 4c vorgesehen werden.

Figur 5 zeigt entsprechend der Figur 2a einen Linsenschnitt einer weiteren Ausführungsform des in der erfindungsgemäßen Beleuchtungseinrichtung vorgesehenen Zoom-Axicons. Es ist zwischen der Ebene 130 des Verschlusses, der eine sekundäre Lichtquelle darstellt, und der Pupillenzwischenebene 30 angeordnet und besteht aus einer ersten Linsengruppe 210, dem Axicon-Paar 220, 230 und der Zoomlinse 240, insoweit entsprechend der Figur 2a. In der ersten Linsengruppe 210 ist nun aber ein zweites Zoomglied mit den Flächen 2121, 2120 vorgesehen, welches bei der gezeigten Einstellung nahtlos an die Fläche 2113 der davor liegenden Linse anliegt. Die Flächen 2113, 2121 haben im Rahmen des sinnvoll Machbaren und optisch Wirksamen gleiche Krümmungsradien. Die zugehörigen beiden Linsen bestehen zudem aus dem gleichen Glas mit einheitlichem Brechungsindex n. Damit sind in der gezeigten Stellung die Flächen 2113, 2121 wie auch die Kegelflächen 2220, 2310 der Axicons 220, 230 optisch ohne Wirkung. Diese Stellung ist für konventionelle Beleuchtung mit kleinem Kohärenzfaktor σ, also kleiner ausgeleuchteter Fläche in der Pupillenzwischenebene 30, geeignet. Eine Ringaperturbeleuchtung wird daraus durch Auseinanderfahren der Axicons 220, 230 entsprechend der Figur 2b.

Figur 6 zeigt für das gleiche Ausführungsbeispiel wie Figur 5 die Stellung für maximalen Kohärenzfaktor σ. Hier ist die Zoomlinse 240 ganz an das Axicon 230 gerückt, gleichzeitig ist das zweite Zoomglied mit den Flächen 2121, 2120 von der Linsenfläche 2113 weit abgerückt bis in die Nachbarschaft der Fläche 2150 der letzten Linse der ersten Linsengruppe 210.

Die Tabelle 2 gibt die Radien, Abstände und Glasarten aller Linsen in dem Objektiv gemäß Figuren 5 und 6 wieder. Die Planplatte 2170, 2180 ist als Filterelement vorgesehen.

Ein Unterschied zur Ausführung der Fig. 2a, 2b besteht im Wesentlichen darin, dass die starke Krümmung der zweiten Fläche 2111 der ersten Linse eine schmalere Ausgestaltung des Randbüschels ergibt.

In der breiten Ausleuchtung haben die zweite (2112, 2113) und dritte (2121, 2120) Linse ihren größtmöglichen Abstand d₂₁₀ voneinander. Dieser Abstand d₂₁₀ zusammen mit der positiven Brechkraft der zweiten Linse (2112, 2113) bewirkt eine Verlagerung des Randbüschels an den Rand des beleuchteten Feldes (30) und damit dort eine höhere Beleuchtungsstärke. Außerdem bewirkt die Verlagerung des Zonenbüschels eine verbesserte Ausleuchtung der Mitte des beleuchteten Feldes (30). Da auf der Lichteintrittsseite (130) in kleinen Winkeln keine Lichtintensität vorhanden ist (Ausleuchtung durch Entladungslampe mit Elektroden in der optischen Achse mit Paraboloidspiegel), wird im vierlinsigen Vergleichssystem der Stammanmeldung die Mitte des beleuchteten Feldes (30) nur gering ausgeleuchtet.

Die Axicon-Wirkung erzeugt eine Ringapertur-Beleuchtung. Die Breite des Ringes wird durch die pankratische Einstellung vorgegeben, die Lage des Ringes wird unabhängig davon durch die Bewegung des Axicon-Elements (230) eingestellt.

Bei maximaler Axicon-Wirkung kombiniert mit der schmalsten pankratischen Einstellung wird der Beleuchtungsstärkeverlauf von Kurve C der Figur 7 wiedergegeben.

Kurve B gilt für die Einstellung gemäß Figur 6, Kurve A gehört zu Figur 5. Im Vergleich zu Figur 3 zeigt sich bei Kurve B die verbesserte Ausleuchtung in der Mitte und am Rand.

Die vorgestellten Varianten sind nur eine Auswahl typischer Beispiele. Auch ist die Anwendung der Erfindung nicht auf die Projektions-Mikrolithographie beschränkt. In einfacherer Ausführung eignet sie sich z.B. auch als variable Mikroskop-Beleuchtung oder als Beleuchtung für Apparate zur Mustererkennung.

**Tabelle 1**

| Wellenlänge 360,00 nm | | | |
|---|---|---|---|
| Nr. | Radius | Dicke | Glasname |
| 13 | plan | 10,20 | |
| 211 | -199,5 | 87,40 | Quarz |
| 212 | -92,4 | 45,20 | |
| 213 | plan | 4,35 | |
| 214 | plan | 46,54 | |
| 215 | 393,8 | 29,00 | FK5 |
| 216 | -302,9 | 2,15 | |
| 217 | plan | 5,00 | FK5 |
| 218 | plan | 2,15 | |
| 221 | 135,3 | 8,00 | FK5 |
| 222 | Kegel | 0,00, variabel | |
| 231 | Kegel | 42,00 | FK5 |
| 232 | 739,1 | 26,53 | |
| 241 | -183,0 | 9,40 | FK5 |
| 242 | 170,3 | 26,38, variabel | |
| 3 | plan | | |
| Kegelwinkel α: 63 Grad für 222 und 231 | | | |

**Tabelle 2**

| Nr. | Radius | Dicke | Glasname |
|---|---|---|---|
| 130 | plan | 35,0 | |
| 2110 | -48,0 | 24,3 | Quarz |
| 2111 | -40,1 | 0,6 | |
| 2112 | -94,4 | 14,6 | FK5 (Schott) |
| 2113 | -56,6 | 0,2 - 130,5(d₂₁₀) | |
| 2121 | -56,6 | 37,4 | FK5 |
| 2120 | -101,5 | 130,4 - 0,2 | |
| 2150 | 578,8 | 21,8 | FK5 |
| 2160 | -254,8 | 2,1 | |
| 2170 | plan | 2,2 | |
| 2180 | plan | 2,1 | |
| 2210 | 154 | 8,0 | FK5 |
| 2220 | Kegel | variabel | |
| 2310 | Kegel | 46,0 | FK5 |
| 2320 | -2512 | 143,1 - 0,2 | |
| 2410 | -2512 | 9,1 | FK5 |
| 2420 | 128,6 | 23,1 - 166 (d₂₄₀) | |
| 30 | plan | | |
| Kegelwinkel α: 62 Grad für 2220, 2310 | | | |

## Patentansprüche

1. Beleuchtungseinrichtung einer mikrolithographischen Projektionsbelichtungsanlage mit einem Zoom-Objektiv (2) zur Verstellung des Kohärenzgrades σ und zwei Axicons (22, 23), die in diesem Zoom-Objektiv angeordnet sind, deren Abstand (d23) verstellbar ist, wobei mindestens ein Axicon (22, 23) als zweite Grenzfläche (221, 223) eine gekrümmte Fläche hat.

2. Beleuchtungseinrichtung einer mikrolithographischen Projektionsbelichtungsanlage mit einem Zoom-Objektiv (2) zur Verstellung des Kohärenzgrades σ und zwei Axicons (22, 23) die in diesem Zoom-Objektiv angeordnet sind, deren Abstand (d23) verstellbar ist, wobei die zwei Axicons (22, 23) in einem nicht kollimierten Strahl angeordnet sind.

3. Beleuchtungseinrichtung nach mindestens einem der Ansprüche 1 bis 2, **dadurch gekennzeichnet, dass** die Axicons (22, 23) soweit fertigungstechnisch machbar und funktionell wirksam gleichen Spitzenwinkel (α) haben.

4. Beleuchtungseinrichtung nach Anspruch 3, **dadurch gekennzeichnet, dass** der Abstand (d23) der Axiconspezifischen Flächen (222, 231) der beiden Axicons (22, 23) bis zur Berührung reduziert werden kann.

5. Beleuchtungseinrichtung nach mindestens einem der Ansprüche 1 bis 4, **dadurch gekennzeichnet, dass** die Axicons (22, 23) konisch sind.

6. Beleuchtungseinrichtung nach mindestens einem der Ansprüche 1 bis 4, **dadurch gekennzeichnet, dass** die Axicons (22, 23) pyramidenförmig sind.

7. Beleuchtungseinrichtung nach mindestens einem der Ansprüche 1 bis 6, **dadurch gekennzeichnet, dass** durch Verstellen des Abstands (d23) der beiden Axicons (22, 23) bzw. der Position mindestens eines Zoom-Linsenglieds (24) stufenlos sowohl konventionelle Beleuchtung als auch Ringapertur- oder Multipolbeleuchtung verschiedener Geometrie eingestellt werden können.

8. Beleuchtungseinrichtung nach mindestens einem der Ansprüche 1 bis 7, **dadurch gekennzeichnet, dass** sie einen Glasstab (5) als Lichtintegrator enthält.

9. Beleuchtungseinrichtung nach Anspruch 8, **dadurch gekennzeichnet, dass** am Austritt des Glasstabs (5) ein Maskierungssystem (51) angeordnet ist.

10. Beleuchtungseinrichtung nach mindestens einem der Ansprüche 1 bis 9, **dadurch gekennzeichnet, dass** eine eine sekundäre Lichtquelle bildende Blende (13) außerhalb des Fokus (121) eines Lampenspiegels (12), angeordnet ist.

11. Beleuchtungseinrichtung nach Anspruch 8, **dadurch gekennzeichnet, dass** nach dem Lichtintegrator (5) keine Blenden zur Formung des Lichtbündels angeordnet sind.

12. Beleuchtungseinrichtung nach mindestens einem der Ansprüche 1 bis 11, enthaltend Anspruch 7, **dadurch gekennzeichnet, dass** die Einstellung programmgesteuert über einen Computer erfolgt.

13. Beleuchtungseinrichtung nach mindestens einem der Ansprüche 1 bis 12, **dadurch gekennzeichnet, dass** zwei Linsen (2121, 2120, 240) des Zoom-Objektivs verschiebbar sind.

14. Beleuchtungseinrichtung nach Anspruch 13, **dadurch gekennzeichnet, dass** eine verschiebbare Linse (2121, 2120) eine Fläche (2121) mit nahezu gleichem Radius wie die benachbarte Fläche (2113) einer feststehenden Linse (2112, 2113) hat, und dass beide Flächen (2113, 2121) bis zur Berührung angenähert werden können.

15. Beleuchtungseinrichtung nach Anspruch 14, **dadurch gekennzeichnet, dass** die eine verschiebbare Linse (2121, 2120) und die eine feststehende Linse (2112, 2113) aus Glas mit gleicher Brechzahl n bestehen.

16. Beleuchtungseinrichtung nach mindestens einem der Ansprüche 13 bis 15, **dadurch gekennzeichnet, dass** für kleine Kohärenzgrade (σ) beide verschiebbaren Linsen (2121, 2120, 240) fern von den beiden Axicons (220, 230) liegen, für großen Kohärenzgrad (σ) nahe dran.

17. Beleuchtungseinrichtung nach Anspruch 1 und fakultativ nach davon abhängigen Ansprüchen 3 bis 16, **dadurch gekennzeichnet, dass** die zwei Axicons (22, 23) in einem nicht kollimierten Strahl angeordnet sind.

18. Beleuchtungseinrichtung nach Anspruch 2 und fakultativ nach davon abhängigen Ansprüchen 3 bis 16 **dadurch gekennzeichnet, dass** mindestens ein Axicon (22, 23) als zweite Grenzfläche (221, 223) eine gekrümmte Fläche hat.

## Claims

1. Illumination device of a microlithography projection exposure machine having a zoom objective (2) for adjusting the degree of coherence σ and two axicons (22, 23) which are arranged in this zoom objective and whose spacing (d23) is adjustable, at least one axicon (22, 23) having a curved surface as second boundary surface (221, 223).

2. Illumination device of a microlithography projection exposure machine having a zoom objective (2) for adjusting the degree of coherence σ and two axicons (22, 23) which are arranged in this zoom objective and whose spacing (d23) is adjustable, the two axicons (22, 23) being arranged in a non-collimated beam.

3. Illumination device according to at least one of Claims 1 to 2, **characterized in that** the axicons (22, 23) have the same apex angle (α) to the extent that this is feasible in terms of production engineering and functionally effective.

4. Illumination device according to Claim 3, **characterized in that** the spacing (d23) of the axicon-specific surfaces (222, 231) of the two axicons (22, 23) can be reduced as far as to make contact.

5. Illumination device according to at least one of Claims 1 to 4, **characterized in that** the axicons (22, 23) are conical.

6. Illumination device according to at least one of Claims 1 to 4, **characterized in that** the axicons (22, 23) are pyramidal.

7. Illumination device according to at least one of Claims 1 to 6, **characterized in that** it is possible to set both conventional illumination and annular aperture illumination or multipole illumination of different geometry continuously by adjusting the spacing (d23) of the two axicons (22, 23) or the position of at least one zoom lens element (24).

8. Illumination device according to at least one of Claims 1 to 7, **characterized in that** it includes a glass rod (5) as light integrator.

9. Illumination device according to Claim 8, **characterized in that** a masking system (51) is arranged at the exit of the glass rod (5).

10. Illumination device according to at least one of Claims 1 to 9, **characterized in that** an aperture (13) forming a secondary light source is arranged outside the focus (121) of a lamp reflector (12).

11. Illumination device according to Claim 8, **characterized in that** no apertures for shaping the light bundle are arranged downstream of the light integrator (5).

12. Illumination device according to at least one of Claims 1 to 11, including Claim 7, **characterized in that** the setting is performed via a computer under

13. Illumination device according to at least one of Claims 1 to 12, **characterized in that** two lenses (2121, 2120, 240) of the zoom objective are displaceable.

14. Illumination device according to Claim 13, **characterized in that** a displaceable lens (2121, 2120) has a surface (2121) having virtually the same radius as the neighbouring surface (2113) of a fixed lens (2112, 2113), and **in that** the two surfaces (2113, 2121) can be brought together as far as to make contact.

15. Illumination device according to Claim 14, **characterized in that** one displaceable lens (2121, 2120) and one fixed lens (2112, 2113) consist of glass having the same refractive index n.

16. Illumination device according to at least one of Claims 13 to 15, **characterized in that** for small degrees of coherence (σ) the two displaceable lenses (2121, 2120, 240) lie remote from the two axicons (220, 230), and for a large degree of coherence (σ) the said lenses lie close thereto.

17. Illumination device according to Claim 1 and optionally according to Claims 3 to 16 dependent thereon, **characterized in that** the two axicons (22, 23) are arranged in a non-collimated beam.

18. Illumination device according to Claim 2 and optionally according to Claims 3 to 16 dependent thereon, **characterized in that** at least one axicon (22, 23) has a curved surface as second boundary surface (221, 223).

## Revendications

1. Dispositif d'éclairage d'une installation d'exposition pour la microlithographie par projection doté d'un objectif zoom (2) pour le réglage du degré de cohérence σ et de deux axicons (22, 23) qui sont disposés dans cet objectif zoom et dont la distance (d23) qui les sépare est réglable, au moins un axicon (22, 23) possédant comme deuxième surface limite (221, 223) une surface incurvée.

2. Dispositif d'éclairage d'une installation d'exposition pour la microlithographie par projection doté d'un objectif zoom (2) pour le réglage du degré de cohérence σ et de deux axicons (22, 23) qui sont disposés dans cet objectif zoom et dont la distance (d23) qui les sépare est réglable, les deux axicons (22, 23) étant disposés dans un rayon non collimaté.

3. Dispositif d'éclairage selon au moins l'une des revendications 1 à 2, **caractérisé en ce que** les axicons (22, 23) présentent des angles (α) égaux dans la mesure où la fonction est remplie et où les techniques de fabrication le permettent.

4. Dispositif d'éclairage selon la revendication 3, **caractérisé en ce que** la distance (d23) entre les surfaces d'axicon spécifiques (222, 231) des deux axicons (22, 23) peut être réduites jusqu'à ce qu'ils se touchent.

5. Dispositif d'éclairage selon au moins l'une des revendications 1 à 4, **caractérisé en ce que** les axicons (22, 23) ont une forme conique.

6. Dispositif d'éclairage selon au moins l'une des revendications 1 à 4, **caractérisé en ce que** les axicons (22, 23) ont une forme de pyramide.

7. Dispositif d'éclairage selon au moins l'une des revendications 1 à 6, **caractérisé en ce que** l'on peut régler en continue un éclairage de type classique, un éclairage à ouverture annulaire ou un éclairage multipolaire de géométrie variable en faisant varier la distance (d23) séparant les deux axicons (22, 23) ou la position d'au moins un élément (24) du zoom.

8. Dispositif d'éclairage selon au moins l'une des revendications 1 à 7, **caractérisé en ce qu'**il comprend une tige de verre (5) servant d'intégrateur de lumière.

9. Dispositif d'éclairage selon la revendication 8, **caractérisé en ce qu'**un système de masquage (51) est disposé à la sortie de la tige de verre (5).

10. Dispositif d'éclairage selon au moins l'une des revendications 1 à 9, **caractérisé en ce qu'**un diaphragme (13) formant source de lumière secondaire est disposé au-dehors du foyer (121) d'un miroir de lampe (12).

11. Dispositif d'éclairage selon la revendication 8, **caractérisé en ce qu'**aucun diaphragme de mise en forme du faisceau lumineux n'est disposé en aval de l'intégrateur de lumière (5).

12. Dispositif d'éclairage selon au moins l'une des revendications 1 à 11, comprenant la revendication 7, **caractérisé en ce que** le réglage est commandé par un programme depuis un ordinateur.

13. Dispositif d'éclairage selon au moins l'une des revendications 1 à 12, **caractérisé en ce que** deux lentilles (2121, 2120, 240) de l'objectif zoom sont mobiles.

14. Dispositif d'éclairage selon la revendication 13, **caractérisé en ce qu'**une lentille mobile (2121, 2120) présente une face (2121) ayant sensiblement le même rayon que la face voisine (2113) d'une lentille fixe (2112, 2113) et que ces deux faces (2113, 2121) peuvent être rapprochées jusqu'à entrer en contact l'une avec l'autre.

15. Dispositif d'éclairage selon la revendication 14, **caractérisé en ce que** la lentille mobile (2121, 2120) et la lentille fixe (2112, 2113) se composent d'un verre ayant le même indice de réfraction n.

16. Dispositif d'éclairage selon au moins l'une des revendications 13 à 15, **caractérisé en ce que** les deux lentilles mobiles (2121, 2120, 240) sont placées dans une position éloignée des deux axicons (220, 230) pour un faible degré de cohérence (σ) et plus proche de ceux-ci pour un haut degré de cohérence (σ).

17. Dispositif d'éclairage selon la revendication 1 et facultativement les revendications 3 à 16 dépendantes de celle-ci, **caractérisé en ce que** les deux axicons (22, 23) sont disposés dans un rayon non collimaté.

18. Dispositif d'éclairage selon la revendication 2 et facultativement les revendications 3 à 16 dépendantes de celle-ci, **caractérisé en ce qu'**au moins un axicon (22, 23) possède comme deuxième surface limite (221, 223) une surface incurvée.
